# EUROPÄISCHE PATENTANMELDUNG

(11) **EP 4 852 696 A1**
(43) Veröffentlichungstag der Anmeldung: **09.12.2026**
(21) Anmeldenummer: 26180563.4
(22) Anmeldetag: 22.05.2026
(51) Int. Cl.: H10P 74/20, H10D 80/20, H10P 74/00, H10W 42/00, H10W 42/80, H10W 70/01, H10W 70/60, H10W 70/65, H10W 72/00, H10W 74/10, G01R 31/42, G01R 31/52, H10W 40/25

(54) **LEISTUNGSMODUL MIT FEHLSTELLE IN VERGUSSMASSE**

(30) Priorität: 06.06.2025 DE 102025122484
(71) Anmelder: Volkswagen Aktiengesellschaft, 38440 Wolfsburg (DE)
(72) Erfinder: Bayer, Christoph Friedrich, 38440 Wolfsburg (DE); Otto, Alexander, 38440 Wolfsburg (DE); Wilke, Robert, 38440 Wolfsburg (DE); Pihale, Sven, 38440 Wolfsburg (DE)

(57) **Zusammenfassung**

Leistungsmodul (1), aufweisend
- einen flächigen Träger (2),
- ein auf eine Oberfläche (8) des Trägers (2) aufgebrachtes erstes Metallisierungspad (3),
- ein auf die Oberfläche (8) des Trägers (2) aufgebrachtes zweites Metallisierungspad (4),
wobei das erste Metallisierungspad (3) und das zweite Metallisierungspad (4) durch einen ersten Zwischenraum (5) voneinander beabstandet sind,
- eine elektrisch isolierende Vergussmasse (6), in welche das erste Metallisierungspad (3) und das zweite Metallisierungspad (4) zumindest teilweise eingegossen sind und die den ersten Zwischenraum (5) zumindest teilweise befüllt, wobei die Vergussmasse (6) eine Fehlstelle (7) aufweist, in welcher der erste Zwischenraum (5) nicht von Vergussmasse (6) befüllt ist und welche sich entlang der Oberfläche (8) des Trägers (2) von dem ersten Metallisierungspad (3) bis zu dem zweiten Metallisierungspad (4) erstreckt, wobei beidseitig und der Fehlstelle (7) der erste Zwischenraum (5) mit der Vergussmasse (6) befüllt ist und die Fehlstelle (7) von oben von der Vergussmasse (6) begrenzt ist.

## Beschreibung

Die vorliegende Erfindung betrifft ein Leistungsmodul mit einer Fehlstelle in einer Vergussmasse, ein Verfahren zu seiner Herstellung und Verfahren zur Feststellung eines Kurzschlusses dem Leistungsmodul.

In einem Pulswechselrichtern (PWR) sind Leistungsmodule vielen unterschiedlichen Umgebungseinflüssen wie z.B. Wärme und Feuchtigkeit ausgesetzt. Trotz Schutzmaßnahmen wie Silikon- oder Moldverguss kann Feuchtigkeit durch diese Materialien eindringen, was zu Alterungseffekten an den Chiprändern oder zu Delaminationen der Moldvergussverbindung zur Chipoberfläche führt. Diese Effekte verringern die Spannungsfestigkeit, beeinflussen die Lebensdauer der Module und können zum Defekt des Leistungsmoduls führen. Das Leistungsmodul kann ausfallen, ohne dass eine Vorwarnung über einen möglichen Defekt möglich ist. Dadurch kann ein Fahrzeug liegen bleiben. Es ist auch möglich, dass ein größerer Schaden des Antriebs entsteht.

C.F. Bayer et al, Electrochemical Corrosion on Ceramic Substrates for Power Electronics - Causes, Phenomenological Description, and Outlook, VDE Fachberichte, März 2018, beschreibt die Korrosion eines leitenden Materials auf keramischen Schaltungsträgern, wobei sich Dendriten von einer Elektrode zur anderen bilden können, wodurch Kurschlüsse verursacht werden.

Es ist nicht bekannt, dass Leistungsmodule während des Einsatzes im Fahrzeug auf die Thematik Lebensdauervorhersage oder den Einfluss von Feuchte auf die Lebensdauer im Betrieb überprüft werden. Bisher wird der Punkt im Vorfeld mit vielen Erprobungsspuren überprüft und gewisse Lebensdauermodelle für die Leistungsmodule angewendet. Jedoch besteht in geringem Maße immer das Risiko, dass Leistungsmodule im Betrieb aufgrund der beschriebenen Thematik
ausfallen, eine Früherkennung ist bisher nicht möglich.

Die Aufgabe der Erfindung war es, eine vereinfachte Möglichkeit zur Früherkennung möglicher Kurzschlüsse in Leistungsmodulen bereitzustellen, insbesondere für den Fall eines durch Dendritenbildung verursachten Kurzschlusses.

Angeben werden von der Erfindung ein Leistungsmodul und ein Verfahren nach den unabhängigen Ansprüchen. Speziellere Ausführungsformen sind in den abhängigen Ansprüchen und dieser Beschreibung angegeben.

Angegeben wird ein Leistungsmodul, aufweisend
- einen flächigen Träger,
- ein auf eine Oberfläche des Trägers aufgebrachtes erstes Metallisierungspad,
- ein auf die Oberfläche des Trägers aufgebrachtes zweites Metallisierungspad,
   wobei das erste Metallisierungspad und das zweite Metallisierungspad durch einen ersten Zwischenraum voneinander beabstandet sind,
- eine elektrisch isolierende Vergussmasse, in welche das erste Metallisierungspad und das zweite Metallisierungspad zumindest teilweise eingegossen sind und die den ersten Zwischenraum zumindest teilweise befüllt, wobei die Vergussmasse eine Fehlstelle aufweist, in welcher der erste Zwischenraum nicht oder nicht vollständig mit Vergussmasse befüllt ist und welche sich entlang der Oberfläche des Trägers von dem ersten Metallisierungspad bis zu dem zweiten Metallisierungspad erstreckt, wobei beidseitig von der Fehlstelle der erste Zwischenraum mit der Vergussmasse befüllt ist und die Fehlstelle von oben von Vergussmasse begrenzt ist.

Durch die Erfindung wird eine Früherkennung von Schäden der Vergussmasse ermöglicht.

Idee der Erfindung ist eine in das Leistungsmodul integrierte Opferstruktur dort, wo die Fehlstelle ausgebildet ist. Die Fehlstelle ist beispielsweise ein Hohlraum oder ein Material, das hydrophil ist.

Die Opferstruktur sind das erste Metallisierungspad und das zweite Metallisierungspad an der Fehlstelle. An der Fehlstelle kann Feuchte eher eindringen als an anderen Stellen im Modul. An der Fehlstelle können sich bei Eindringen von Feuchtigkeit Dendriten zwischen dem ersten Metallisierungspad und dem zweiten Metallisierungspad entlang der Oberfläche des Trägers bilden, die den Zwischenraum überbrücken und zu einem Kurzschluss führen. Dies ist ein Indiz dafür, dass die Vergussmasse fehlerhaft ist oder sich von einer Oberfläche des Trägers, des ersten Metallisierungspads, und/oder des zweiten Metallisierungspads gelöst hat und das Eindringen von Feuchtigkeit ermöglicht wurde. Dendriten sind ein Maß für Feuchte im Modul und für Degradation und stellen ein Frühwarnsystem in der Opferstruktur dar. Es kann bei einem Kurzschluss in der Opferstruktur rückgeschlossen oder zumindest als wahrscheinlich betrachtet werden, dass die Vergussmasse auch an anderen Stellen fehlerhaft oder abgelöst ist und das Leistungsmodul kann frühzeitig als fehlerhaft erkannt und ausgetauscht werden.

Die Dendritenbildung bzw. der dadurch bedingte Kurzschluss kann durch Auswertung einer Spannung oder eines Leckstroms ermittelt werden. Es kann ein Schaden, eine Delamination, ein Feuchteeintritt, eine Korrosionserscheinung (Dendritenstruktur) im Modul erkannt werden, welche zu einem späteren Ausfall des Moduls führen würde.

Die Fehlstelle ist ein Raum innerhalb des Leistungsmoduls zwischen dem ersten Metallisierungspad und dem zweiten Metallisierungspad, der nicht mit Vergussmasse befüllt ist. Die Fehlstelle ist in dem Zwischenraum zwischen dem ersten Metallisierungspad und dem zweiten Metallisierungspad angeordnet, der auch als Isolationsgraben bezeichnet wird. Die Fehlstelle wird von dem ersten Metallisierungspad, dem zweiten Metallisierungspad, der Oberfläche des Trägers und der Vergussmasse umgrenzt. Die Fehlstelle liegt in dem Zwischenraum zwischen dem ersten Metallisierungspad und dem zweiten Metallisierungspad. Die Fehlstelle weist bei einer dichten Verbindung der Vergussmasse zum Träger beidseitig der Fehlstelle und bei einer dichten Verbindung der Vergussmasse zu den Metallisierungspads keine Verbindung nach Außen auf.

Der flächige Träger ist beispielsweise ein keramischer Träger.

Die Metallisierungspads sind beispielsweise aus Kupfer.

Die Vergussmasse ist eine ausgehärtete Vergussmasse. Bei der Herstellung des Leistungsmoduls wird eine Flüssigkeit

Die Vergussmasse ist beispielsweise ein Kunstharz, wie zum Beispiel ein Epoxid-Harz.

Das Leistungsmodul kann übliche Komponenten eines Leistungsmoduls aufweisen, wobei beispielhaft und nicht erschöpfend erwähnt sind: Leistungshalbleiter, Bonddrähte, Anschlussbleche, Anschlusspins und dergleichen.

In einer Ausführungsform weist das Leistungsmodul auf:
- Anschlussstellen oder eine Einrichtung zur Messung eines Stroms oder einer Spannung zwischen den Metallisierungspads.

Mit dieser Ausführungsform kann vorteilhaft ein Kurzschlussstrom oder eine bei Kurzschluss abfallende Spannung ermittelt werden. Von den Anschlusstellen ist eine mit dem ersten Metallisierungspad elektrisch kontaktiert und eine zweite mit dem zweiten Metallisierungspad elektrisch kontaktiert. An die Anschlussstellen kann ein Gerät zur Messung eines Stroms oder einer Spannung angeschlossen werden. Die Einrichtung zur Messung eines Stroms oder einer Spannung weist die erwähnten Anschlussstellen und das Gerät zur Messung eines Stroms oder einer Spannung auf.

In einer Ausführungsform weist das Leistungsmodul auf:
- eine Spannungsquelle, mit der eine Spannung zwischen dem ersten Metallisierungspad und dem zweiten Metallisierungspad erzeugbar ist.

Zwischen dem ersten Metallisierungspad und dem zweiten Metallisierungspad kann im Betrieb des Leistungsmoduls eine Potentialdifferenz bestehen, die ein Dendritenwachstum in der Fehlstelle befördert. Wenn dies nicht der Fall ist, kann durch die Spannungsquelle in dieser Ausführungsform eine Spannung erzeugt werden oder es kann eine höhere Spannung erzeugt werden, um bei einem schadhaften Leistungsmodul das Dendritenwachstum in der Fehlstelle zu befördern und eine Undichtigkeit der Vergussmasse schneller zu erkennen.

In einer Ausführungsform ist die Fehlstelle ein Hohlraum. Hierin kann sich Feuchtigkeit gut sammeln und das Dendritenwachstum in der der Fehlstelle wird befördert, um eine Undichtigkeit der Vergussmasse schneller zu erkennen.

In einer Ausführungsform ist die Fehlstelle mit einem elektrisch isolierenden Festkörper ausgefüllt, der an der Oberfläche des Trägers anliegt und keine wasserdichte Verbindung zu der Oberfläche des Trägers aufweist. Der Festkörper kann hydrophil sein. Diese Ausführungsform lässt eine einfache Herstellung des Leistungsmoduls zu, da der Festkörper beim Vergießen mit zu Vergussmasse härtbarer Flüssigkeit und Härten der Vergussmasse als Positivform der Fehlstelle dient und nicht entfernt werden muss. Durch die nicht wasserdichte Verbindung kann Feuchtigkeit zwischen Festkörper und Oberfläche des Trägers eindringen und das Dendritenwachstum wird ermöglicht.

In einer Ausführungsform ist das erste Metallisierungspad und/oder das zweite Metallisierungspad benachbart zu einem Rand des Trägers angeordnet. Dies bedeutet, dass zwischen dem betreffenden Metallisierungspad und dem Rand kein weiteres Metallisierungspad angeordnet ist. In dieser Ausführungsform sind auch der Zwischenraum und die Fehlstelle nahe des Randes des Trägers angeordnet. Eine solche Anordnung der Fehlstelle nahe des Randes des Trägers ist vorteilhaft zur frühzeitigen Erkennung einer Undichtigkeit der Vergussmasse, da eine Delamination der der Vergussmasse von dem Träger erwartungsgemäß am Rand des Trägers beginnt.

In einer Ausführungsform weist das Leistungsmodul auf:
- ein auf eine Oberfläche des Trägers aufgebrachtes drittes Metallisierungspad,
- ein auf die Oberfläche des Trägers aufgebrachtes viertes Metallisierungspad
   wobei das dritte Metallisierungspad und das vierte Metallisierungspad durch einen zweiten Zwischenraum voneinander beabstandet sind,
   wobei der zweite Zwischenraum nicht mit Vergussmasse befüllt ist.

In dieser Ausführungsform wird eine zweite Opferstruktur bereitgestellt, die per se nicht gegen Feuchtigkeit geschützt ist und außerhalb der Vergussmasse liegt. Durch Kopplung dieser beiden Opferstrukturen kann eine Differenz in der Feuchtigkeit oder dem Dendritenwachstum gemessen werden, aus der sich ein möglicher Schaden bzw. Reduzierung der Lebensdauer ableiten lässt. Ein beispielhaftes Verfahren dazu ist nachfolgend noch angegeben.

In einem weiteren Aspekt betrifft die Erfindung ein Verfahren zur Feststellung eines Kurzschlusses in einem Leistungsmodul, wobei das Verfahren aufweist:
- Bereitstellen eines Leistungsmoduls wie vorangehend beschrieben,
- Messen eines Stroms oder einer Spannung zwischen dem ersten Metallisierungspad und dem zweiten Metallisierungspad,
- Feststellen einer über die Zeit stattfindenden Erhöhung des Stroms oder einer über die Zeit abfallenden Spannung, wodurch ein Kurzschluss indiziert ist.

Bei diesem Verfahren, und weiteren nachfolgend noch vorgestellten Verfahren, können einzeln oder in Kombination die vorangehend anhand eines Leistungsmoduls beschriebenen Merkmale Anwendung finden. Vorangehend bereits genannte verfahrensartige Merkmale können in diesem Verfahren Anwendung finden. Vorangehend bereits genannte strukturelle Merkmale können in diesen Verfahren Anwendung finden.

Die Erhöhung des Stroms oder der Abfall können kontinuierlich oder abrupt auftreten, je nach Ausbildung der Dendritenstruktur, die zu einem Kurzschluss führt.

In einem weiteren Aspekt betrifft die Erfindung ein weiteres Verfahren zur Feststellung eines Kurzschlusses in einem Leistungsmodul, wobei das Verfahren aufweist:
- Bereitstellen eines Leistungsmoduls, das wie vorangehend beschrieben ein drittes Metallisierungspad und ein viertes Metallisierungspad aufweist,
- Messen eines Stroms oder einer Spannung zwischen dem ersten Metallisierungspad und dem zweiten Metallisierungspad,
- Messen eines Stroms oder einer Spannung zwischen dem dritten Metallisierungspad und dem vierten Metallisierungspad,
wobei das Verfahren weiterhin eine oder mehrere der folgenden Maßnahmen aufweist:
- Feststellen ob bei einer über die Zeit stattfindenden Erhöhung des Stroms zwischen dem dritten Metallisierungspad und dem vierten Metallisierungspad auch eine Erhöhung des Stroms des zwischen dem ersten Metallisierungspad und dem zweiten Metallisierungspad erfolgt, wodurch ein Kurzschluss zwischen dem ersten Metallisierungspad und dem zweiten Metallisierungspad indiziert ist,
   und/oder
- Feststellen ob bei einem über die Zeit stattfindenden Abfall der Spannung zwischen dem dritten Metallisierungspad und dem vierten Metallisierungspad auch ein Abfall der Spannung zwischen dem ersten Metallisierungspad und dem zweiten Metallisierungspad erfolgt, wodurch ein Kurzschluss indiziert ist.

Ein Dendritenwachstum zwischen dem dritten Metallisierungspad und dem vierten Metallisierungspad ist nicht durch Vergussmasse gehindert und bei Anwesenheit von ausreichend Feuchtigkeit wird ein Dendritenwachstum stattfinden und zu einem Kurzschluss führen. Die Kurzschlussspannung oder der Kurzschlussstrom dienen als Vergleich zu einem zwischen dem ersten Metallisierungspad und dem zweiten Metallisierungspad gemessenen Strom oder Spannung. Bei gleicher oder ähnlicher Strom- oder Spannungsänderung kann auf einen Kurzschluss auch zwischen dem ersten Metallisierungspad und dem zweiten Metallisierungspad geschlossen werden.

Vorzugsweise liegen an dem ersten Metallisierungspad und dem zweiten Metallisierungspad einerseits und dem dritten Metallisierungspad, und dem vierten Metallisierungspad andererseits, gleiche Potentiale an. Vorzugsweise sind der erste Zwischenraum zwischen dem ersten Metallisierungspad und dem zweiten Metallisierungspad einerseits, und der zweite Zwischenraum zwischen dem dritten Metallisierungspad und dem vierten Metallisierungspad andererseits, gleich dimensioniert.

In noch einem weiteren Aspekt betrifft die Erfindung ein Verfahren zur Herstellung eines vorangehend beschriebenen Leistungsmoduls, wobei das Verfahren aufweist:
- Bereitstellen eines flächigen Trägers mit einem auf eine Oberfläche des Trägers aufgebrachten ersten Metallisierungspad und einem auf die Oberfläche des Trägers aufgebrachten zweiten Metallisierungspad,
   wobei das erstes Metallisierungspad und das zweite Metallisierungspad durch einen Zwischenraum voneinander beabstandet sind,
- Einbringen eines elektrisch isolierenden Festkörpers in den Zwischenraum, wobei sich der Festkörper von dem ersten Metallisierungspad bis zu dem zweiten Metallisierungspad erstreckt und an der Oberfläche des Trägers anliegt,
- Vergießen mit einer zu einer elektrisch isolierenden Vergussmasse härtbaren Flüssigkeit, in welche das erste Metallisierungspad, das zweite Metallisierungspad und der elektrisch isolierende Festkörper eingegossen werden, und Aushärten der Flüssigkeit zu der elektrisch isolierenden Vergussmasse.

Nach dem Vergießen und Härten ist die Fehlstelle mit einem elektrisch isolierenden Festkörper ausgefüllt, der an der Oberfläche des Trägers anliegt und keine wasserdichte Verbindung zu der Oberfläche des Trägers aufweist. Der Festkörper kann hydrophil sein.

In einer Ausführungsform weist das Verfahren zur Herstellung des Leistungsmoduls auf:
- Das Entfernen oder Zersetzen des Festkörpers.

In dieser Ausführungsform ist nach dem Zersetzen des Festkörpers die Fehlstelle ein bereits zuvor erwähnter Hohlraum. Das Zersetzen ist beispielsweise ein thermisches Zersetzen.

Nachfolgend wird die Erfindung anhand von Beispielen beschrieben. Es zeigen:
- Fig. 1: ein erfindungsgemäßes Leistungsmodul;
- Fig. 2: ein Detail des erfindungsgemäßen Leistungsmoduls;
- Fig. 3: den Ablauf eines ersten erfindungsgemäßen Verfahrens zur Feststellung eines Kurzschlusses;
- Fig. 4: den Ablauf eines zweiten erfindungsgemäßen Verfahrens zur Feststellung eines Kurzschlusses;
- Fig. 5: den Ablauf eines erfindungsgemäßen Verfahrens zur Herstellung eines erfindungsgemäßen Leistungsmoduls.

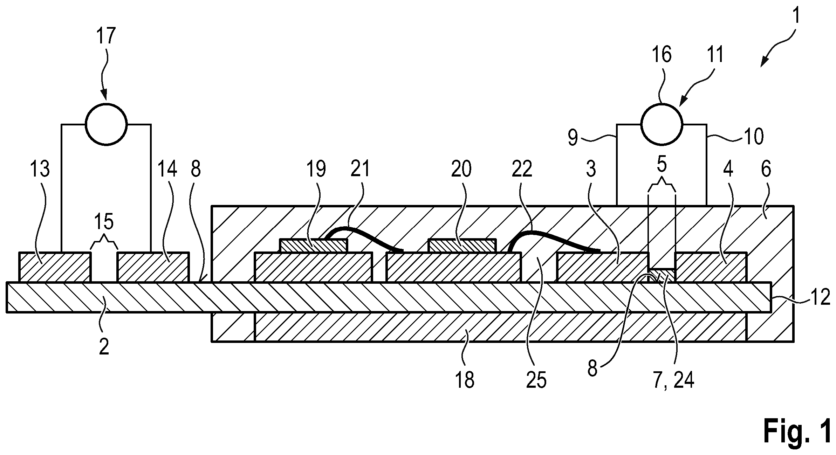

Das in Fig. 1 gezeigte Leistungsmodul 1 weist den keramischen Träger 2 auf, auf dessen Oberfläche 8 das erste Metallisierungspad 3, das zweite Metallisierungspad 4, das dritte Metallisierungspad 13 und das vierte Metallisierungspad 14 aufgebracht sind. Zwischen dem ersten Metallisierungspad 3 und dem vierten Metallisierungspad 14 sind zwei weitere nicht mit Bezugszeichen versehene Metallisierungspads angeordnet, von denen eines den Leistungshalbleiter 19 und ein anderes den Leistungshalbleiter 20 trägt. Die Leistungshalbleiter 19 und 20 sind jeweils mit einem Bonddraht 21, 22 an benachbarte Metallisierungspads kontaktiert, so der Leistungshalbleiter 20 über den Bonddraht 22 an das erste Metallisierungspad 3.

Auf der Unterseite des keramischen Trägers 2 ist die Metallisierungsschicht 18 aufgebracht, an welche ein nicht dargestellter Kühler angebracht werden kann.

Die Vergussmasse 6 umhüllt einen Teil des Trägers 2, und das erste Metallisierungspad 3 und das zweite Metallisierungspad 4, nicht aber das dritte Metallisierungspad 13 und das vierte Metallisierungspad 14. Das zweite Metallisierungspad 4 liegt benachbart zum Rand 12 des Trägers 2 in der Vergussmasse 6.

Das erste Metallisierungspad 3 und das zweite Metallisierungspad 4 sind durch den ersten Zwischenraum 5 voneinander getrennt, der grabenförmig ausgestaltet ist und in Blickrichtung des Betrachters verläuft. In dem Zwischenraum 5 ist die Fehlstelle 7 gebildet, in welcher der Zwischenraum 5 nicht vollständig mit Vergussmasse 6 gefüllt ist. In Blickrichtung des Betrachters ist vor und hinter der Fehlstelle der Zwischenraum 5 mit Vergussmasse 6 gefüllt, in analoger Weise wie in dem weiteren Zwischenraum 25 zwischen dem ersten Metallisierungspad 3 und dem links davon liegenden Metallisierungspad zu sehen.

In dem Zwischenraum 5 befindet sich der Festkörper 24, der an der Oberfläche 8 des Trägers 2 anliegt aber keine wasserdichte Verbindung zu der Oberfläche 8 des Trägers 2 aufweist, sodass zwischen den Festkörper 24 und die Oberfläche 8 des Trägers 2 Feuchtigkeit eindringen kann. Alternativ zu dieser Darstellung kann der Zwischenraum 5 ein unausgefüllter Hohlraum sein, wofür man sich den Festkörper 24 wegdenken muss.

Das erste Metallisierungspad 3 weist die Anschlussstelle 9 auf, und das zweite Metallisierungspad 4 weist die Anschlussstelle 10 auf. Zusammen mit dem Messgerät 16 für Strom oder Spannung bilden die Anschlussstellen 9 und 10 die Einrichtung 11 zur Messung eines Stroms oder einer Spannung zwischen dem ersten Metallisierungspad 3 und dem zweiten Metallisierungspad 4.

Das dritte Metallisierungspad 13 und das vierte Metallisierungspad 14 sind durch den zweiten Zwischenraum 15 voneinander getrennt, der grabenförmig ausgestaltet ist und in Blickrichtung des Betrachters verläuft. Eine Einrichtung 17 zur Messung eines Stroms oder einer Spannung zwischen dem dritten Metallisierungspad 13 und dem vierten Metallisierungspad 14 ist analog aufgebaut wie die Einrichtung 16.

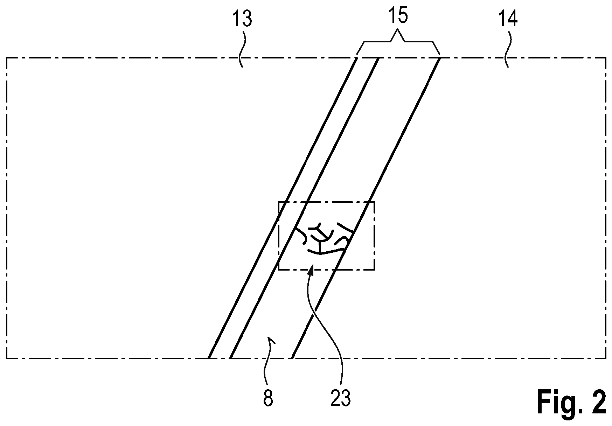

Fig. 2 zeigt am Beispiel des dritten Metallisierungspads 13 und des vierten Metallisierungspads 14, wie sich bei Einfluss von Feuchtigkeit in dem zweiten Zwischenraum 15 Dendriten 23 auf und entlang der Oberfläche 8 bilden, die bei ausreichendem Wachstum den zweiten Zwischenraum 15 überbrücken, sodass zwischen den dritten Metallisierungspad 13 und dem vierten Metallisierungspad 14 eine ungewollte elektrische Verbindung hergestellt wird, die einen Kurzschluss verursacht. Bei Metallisierungspads aus Kupfer sind die Dendriten aus Kupferoxid, CuO. Näheres zum Mechanismus ist dem eingangs genannten Stand der Technik von C.F. Bayer et. al. beschrieben.

Eine Dendritenbildung wie in Fig. 2 gezeigt findet auch in der Fehlstelle 7 in dem ersten Zwischenraum 5 entlang der Oberfläche 8 statt, wenn Feuchtigkeit in die Fehlstelle 7 eindringt. Dies ist ein Indiz für eine beschädigte undichte Vergussmasse 6 oder eine Ablösung der Vergussmasse 6 von der Oberfläche 8 ist. Hier setzen die erfindungsgemäßen Verfahren an.

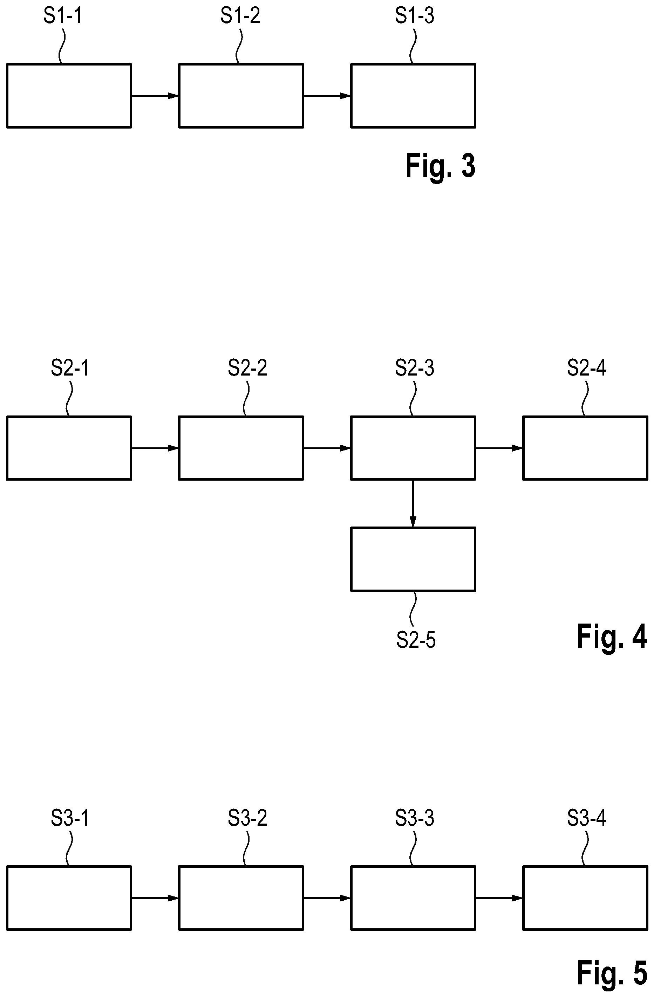

Bei einem ersten Verfahren, schematisch dargestellt in Fig. 3, wird wie folgt vorgegangen:
Es erfolgt zunächst das Bereitstellen S1-1 eines vorangehend beschriebenen Leistungsmoduls 1. Zwischen dem ersten Metallisierungspad 3 und dem zweiten Metallisierungspad 4 erfolgt dann mit der Einrichtung 11 das Messen S1-2 eines Stroms oder einer Spannung. Wird in S1-3 eine über die Zeit stattfindende Erhöhung des Stroms oder eine über die Zeit abfallende Spannung festgestellt, ist ein durch Dendritenbildung verursachter Kurzschluss indiziert. Es kann dann rückgeschlossen werden, dass eine Beschädigung oder Ablösung der Vergussmasse 6 erfolgt ist und das schadhafte Leistungsmodul 1 kann ausgetauscht werden.

In einem alternativen Verfahren gemäß Fig. 4 werden das dritte Metallisierungspad 13 und das vierte Metallisierungspad 14 zur Messung mit herangezogen. Diese sind gegen in den Zwischenraum 15 eindringende Feuchtigkeit ungeschützt und stellen eine Vergleichs-Opferstruktur dar.

Zunächst erfolgt wieder das Bereitstellen S2-1 des Leistungsmoduls 1. Danach erfolgt ebenfalls ein Messen S2-2 eines Stroms oder einer Spannung zwischen dem ersten Metallisierungspad 3 und dem zweiten Metallisierungspad 4, wobei das Messen mit der Einrichtung 11 erfolgt.

Weiterhin erfolgt das Messen S2-3 eines Stroms oder einer Spannung zwischen dem dritten Metallisierungspad 13 und dem vierten Metallisierungspad 14 mit der Einrichtung 17.

Es kann in S2-4 festgestellt werden, ob bei einer über die Zeit stattfindenden Erhöhung des Stroms zwischen dem dritten Metallisierungspad 13 und dem vierten Metallisierungspad 14, was auf einen Kurzschluss durch Dendritenbildung in dem Zwischenraum 15 hinweist, auch eine Erhöhung des Stroms des zwischen dem ersten Metallisierungspad 3 und dem zweiten Metallisierungspad 4 erfolgt, wodurch ein Kurzschluss zwischen dem ersten Metallisierungspad 3 und dem zweiten Metallisierungspad 4 indiziert ist. Die Erhöhung des Stroms zwischen dem dritten Metallisierungspad 13 und dem vierten Metallisierungspad 14 kann mit der Erhöhung des Stroms zwischen dem ersten Metallisierungspad 3 und dem zweiten Metallisierungspad 14 verglichen werden, wobei bei ähnlicher oder gleicher Stromerhöhung eine gleiche Ursache, Kurzschluss durch Dendritenbildung angenommen werden kann. Vorzugsweise sind der erste Zwischenraum 5 und der zweite Zwischenraum 15 gleich dimensioniert.

Dasselbe Prinzip kann mit einer Spannungsmessung statt, oder zusätzlich zu, einer Strommessung erfolgen. Es erfolgt dann ein Feststellen S2-5 ob bei einem über die Zeit stattfindenden Abfall der Spannung zwischen dem dritten Metallisierungspad 13 und dem vierten Metallisierungspad 14 auch ein Abfall der Spannung zwischen dem ersten Metallisierungspad 3 und dem zweiten Metallisierungspad 4 erfolgt, wodurch ein Kurzschluss indiziert ist. Die Spannungsverläufe können verglichen werden.

In Fig. 5 ist ein Verfahren zur Herstellung eines Leistungsmoduls 1 schematisch dargestellt. Zunächst wird in S3-1 der in Fig. 1 dargestellte flächige Träger 2 mit dem auf der Oberfläche 8 des Trägers 2 aufgebrachten ersten Metallisierungspad 3 und dem auf der Oberfläche 8 des Trägers 2 aufgebrachten zweiten Metallisierungspad 4 bereitgestellt. Dann wird in S3-2 der elektrisch isolierende Festkörpers 24 in den ersten Zwischenraum 5 eingebracht, wobei der Festkörper 24 so dimensioniert ist, dass er sich von dem ersten Metallisierungspad 3 bis zu dem zweiten Metallisierungspad 4 erstreckt und an der Oberfläche 8 des Trägers 2 anliegt. Schließlich erfolgt das Vergießen S3-3 mit einer zu der elektrisch isolierenden Vergussmasse 6 härtbaren Flüssigkeit, in welche das erste Metallisierungspad 3, das zweite Metallisierungspad 4 und der elektrisch isolierende Festkörper 24 wie in Fig. 1 gezeigt eingegossen werden und das Aushärten der Vergussmasse 6. Optional kann in S3-4, nach Aushärten der Vergussmasse 6, der Festkörper 24 entfernt oder zersetzt werden, um eine als Hohlraum ausgebildete Fehlstelle 7 zu bilden.

### Bezugszeichenliste

- 1: Leistungsmodul
- 2: Träger
- 3: erstes Metallisierungspad
- 4: zweites Metallisierungspad
- 5: erster Zwischenraum
- 6: Vergussmasse
- 7: Fehlstelle
- 8: Oberfläche des Trägers
- 9: Anschlussstelle
- 10: Anschlussstelle
- 11: Einrichtung zur Messung eines Stroms oder einer Spannung
- 12: Rand des Trägers
- 13: drittes Metallisierungspad
- 14: viertes Metallisierungspad
- 15: zweiter Zwischenraum
- 16: Messgerät für Strom oder Spannung
- 17: Einrichtung zur Messung eines Stroms oder einer Spannung
- 18: Metallisierungsschicht
- 19: Leistungshalbleiter
- 20: Leistungshalbleiter
- 21: Bonddraht
- 22: Bonddraht
- 23: Dendriten
- 24: Festkörper
- 25: weiterer Zwischenraum

- S1-1: Bereitstellen eines Leistungsmoduls 1
- S1-2: Messen eines Stroms oder einer Spannung zwischen dem ersten Metallisierungspad 3 und dem zweiten Metallisierungspad 4
- S1-3: Feststellen einer über die Zeit stattfindenden Erhöhung des Stroms oder einer über die Zeit abfallenden Spannung
- S2-1: Bereitstellen eines Leistungsmoduls 1
- S2-2: Messen eines Stroms oder einer Spannung zwischen dem ersten Metallisierungspad 3 und dem zweiten Metallisierungspad 4
- S2-3: Messen eines Stroms oder einer Spannung zwischen dem dritten Metallisierungspad 13 und dem vierten Metallisierungspad 14
- S2-4: Feststellen ob bei einer über die Zeit stattfindenden Erhöhung des Stroms zwischen dem dritten Metallisierungspad 13 und dem vierten Metallisierungspad 14 auch eine Erhöhung des Stroms des zwischen dem ersten Metallisierungspad 3 und dem zweiten Metallisierungspad 4 erfolgt
- S2-5: Feststellen ob bei einem über die Zeit stattfindenden Abfall der Spannung zwischen dem dritten Metallisierungspad 13 und dem vierten Metallisierungspad 14 auch ein Abfall der Spannung zwischen dem ersten Metallisierungspad 3 und dem zweiten Metallisierungspad 4 erfolgt
- S3-1: Bereitstellen eines flächigen Trägers 2 mit einem auf eine Oberfläche 8 des Trägers 2 aufgebrachten ersten Metallisierungspad 3 und zweiten Metallisierungspad 4
- S3-2: Einbringen eines elektrisch isolierenden Festkörpers 24 in den ersten Zwischenraum 5
- S3-3: Vergießen mit einer zu der elektrisch isolierenden Vergussmasse 6 härtbaren Flüssigkeit und Aushärten zu der elektrisch isolierenden Vergussmasse 6
- S3-4: Entfernen oder Zersetzen des Festkörpers 24

## Patentansprüche

1. Leistungsmodul (1), aufweisend
- einen flächigen Träger (2),
- ein auf eine Oberfläche (8) des Trägers (2) aufgebrachtes erstes Metallisierungspad (3),
- ein auf die Oberfläche (8) des Trägers (2) aufgebrachtes zweites Metallisierungspad (4),
wobei das erste Metallisierungspad (3) und das zweite Metallisierungspad (4) durch einen ersten Zwischenraum (5) voneinander beabstandet sind,
- eine elektrisch isolierende Vergussmasse (6), in welche das erste Metallisierungspad (3) und das zweite Metallisierungspad (4) zumindest teilweise eingegossen sind und die den ersten Zwischenraum (5) zumindest teilweise befüllt, wobei die Vergussmasse (6) eine Fehlstelle (7) aufweist, in welcher der erste Zwischenraum (5) nicht oder nicht vollständig mit Vergussmasse (6) befüllt ist und welche sich entlang der Oberfläche (8) des Trägers (2) von dem ersten Metallisierungspad (3) bis zu dem zweiten Metallisierungspad (4) erstreckt, wobei beidseitig von der Fehlstelle (7) der erste Zwischenraum (5) mit der Vergussmasse (6) befüllt ist und die Fehlstelle (7) von oben von der Vergussmasse (6) begrenzt ist.

2. Leistungsmodul (1) nach Anspruch 1, aufweisend
- Anschlussstellen (9; 10) oder eine Einrichtung (11) zur Messung eines Stroms oder einer Spannung zwischen dem ersten Metallisierungspad (3) und dem zweiten Metallisierungspad (4).

3. Leistungsmodul (1) nach einem der vorangehenden Ansprüche, aufweisend
- eine Spannungsquelle, mit der eine Spannung zwischen dem ersten Metallisierungspad (3) und dem zweiten Metallisierungspad (4) erzeugbar ist.

4. Leistungsmodul (1) nach einem der vorangehenden Ansprüche, wobei die Fehlstelle (7) ein Hohlraum ist.

5. Leistungsmodul (1) nach einem der Ansprüche 1 bis 3, wobei die Fehlstelle (7) mit einem elektrisch isolierenden Festkörper (24) ausgefüllt ist, der an der Oberfläche (8) des Trägers (2) anliegt und keine wasserdichte Verbindung zu der Oberfläche (8) des Trägers (2) aufweist.

6. Leistungsmodul (1) nach einem der vorangehenden Ansprüche, wobei das erste Metallisierungspad (3) und/oder das zweite Metallisierungspad (4) benachbart zu einem Rand (12) des Trägers (2) angeordnet ist.

7. Leistungsmodul (1) nach einem der vorangehenden Ansprüche, aufweisend
- ein auf eine Oberfläche (8) des Trägers (2) aufgebrachtes drittes Metallisierungspad (13),
- ein auf die Oberfläche (8) des Trägers (2) aufgebrachtes viertes Metallisierungspad (14),
wobei das dritte Metallisierungspad (13) und das vierte Metallisierungspad (14) durch einen zweiten Zwischenraum (15) voneinander beabstandet sind,
wobei der zweite Zwischenraum (15) nicht mit Vergussmasse (6) befüllt ist.

8. Verfahren zur Feststellung eines Kurzschlusses in einem Leistungsmodul (1), aufweisend,
- Bereitstellen (S1-1) eines Leistungsmoduls (1) nach einem der Ansprüche 1 bis 7,
- Messen (S1-2) eines Stroms oder einer Spannung zwischen dem ersten Metallisierungspad (3) und dem zweiten Metallisierungspad (4),
- Feststellen (S1-3) einer über die Zeit stattfindenden Erhöhung des Stroms oder einer über die Zeit abfallenden Spannung, wodurch ein Kurzschluss indiziert ist.

9. Verfahren zur Feststellung eines Kurzschlusses in einem Leistungsmodul (1), aufweisend,
- Bereitstellen (S2-1) eines Leistungsmoduls (1) nach Anspruch 7,
- Messen (S2-2) eines Stroms oder einer Spannung zwischen dem ersten Metallisierungspad (3) und dem zweiten Metallisierungspad (4),
- Messen (S2-3) eines Stroms oder einer Spannung zwischen dem dritten Metallisierungspad (13) und dem vierten Metallisierungspad (14),
wobei das Verfahren weiterhin eine oder mehrere der folgenden Maßnahmen aufweist:
- Feststellen (S2-4) ob bei einer über die Zeit stattfindenden Erhöhung des Stroms zwischen dem dritten Metallisierungspad (13) und dem vierten Metallisierungspad (14) auch eine Erhöhung des Stroms des zwischen dem ersten Metallisierungspad (3) und dem zweiten Metallisierungspad (4) erfolgt, wodurch ein Kurzschluss zwischen dem ersten Metallisierungspad (3) und dem zweiten Metallisierungspad (4) indiziert ist, und/oder
- Feststellen (S2-5) ob bei einem über die Zeit stattfindenden Abfall der Spannung zwischen dem dritten Metallisierungspad (13) und dem vierten Metallisierungspad (14) auch ein Abfall der Spannung zwischen dem ersten Metallisierungspad (3) und dem zweiten Metallisierungspad (4) erfolgt, wodurch ein Kurzschluss indiziert ist.

10. Verfahren zur Herstellung eines Leistungsmoduls (1) nach einem der Ansprüche 1 bis 7, aufweisend:
- Bereitstellen (S3-1) eines flächigen Trägers (2) mit einem auf eine Oberfläche (8) des Trägers (2) aufgebrachten ersten Metallisierungspad (3) und einem auf die Oberfläche (8) des Trägers (2) aufgebrachten zweiten Metallisierungspad (4),
wobei das erste Metallisierungspad (3) und das zweite Metallisierungspad (4) durch einen ersten Zwischenraum (5) voneinander beabstandet sind,
- Einbringen (S3-2) eines elektrisch isolierenden Festkörpers (24) in den ersten Zwischenraum (5), wobei sich der Festkörper (24) von dem ersten Metallisierungspad (3) bis zu dem zweiten Metallisierungspad (4) erstreckt und an der Oberfläche (8) des Trägers (2) anliegt,
- Vergießen (S3-3) mit einer zu einer elektrisch isolierenden Vergussmasse (6) härtbaren Flüssigkeit, in welche das erste Metallisierungspad (3), das zweite Metallisierungspad (4) und der elektrisch isolierende Festkörper (24) eingegossen werden und Aushärten der Flüssigkeit zu der elektrisch isolierenden Vergussmasse (6).

11. Verfahren nach Anspruch 10 zur Herstellung eines Leistungsmoduls (1), aufweisend
- Entfernen (S3-4) oder Zersetzen des Festkörpers (24).
